# FASCICULE DE BREVET EUROPEEN

(11) **EP 0 848 087 B1**
(45) Date de publication et mention de la délivrance du brevet: **03.04.2002**
(21) Numéro de dépôt: 97402991.0
(22) Date de dépôt: 10.12.1997
(51) Int. Cl.: C30B 11/00

(54) **Dispositif et procédé de cristallogenèse**
Vorrichtung und Verfahren zur Kristallzüchtung
Apparatus and method for crystal growth

(30) Priorité: 12.12.1996 FR 9615280
(43) Date de publication de la demande: 17.06.1998
(73) Titulaire: COMMISSARIAT A L'ENERGIE ATOMIQUE, 75015 Paris (FR); CENTRE NATIONAL D'ETUDES SPATIALES, F-75039 Paris Cedex 01 (FR)
(72) Inventeur: Duffar, Thierry, 38700 Corenc (FR); Abadie, Jacques, 38360 Sassenage (FR); Dusserre, Pierre, 38120 Saint-Egreve (FR)
(74) Mandataire: Ilgart, Jean-Christophe

(56) Documents cités:
- EP-A- 0 070 760
- EP-A- 0 565 415
- FR-A- 2 345 253

## Description

L'invention a trait à un dispositif de cristallogenèse dans un creuset par la solidification d'un liquide mis en présence d'un germe du cristal.

On emplit donc le creuset du liquide après y avoir déposé le germe, puis on déplace ou retire progressivement les moyens de chauffage qui maintiennent le liquide à cet état : le liquide se solidifie d'abord près du germe, puis l'interface liquide-solide se déplace vers le haut du creuset jusqu'à ce que la solidification soit complète. Comme le solide nouvellement formé reproduit la structure cristallographique du solide adjacent formé auparavant, le germe impose de proche en proche sa structure cristallographique à tout le contenu du creuset.

Un problème de ces procédés est cependant lié aux dilatations thermiques différentielles du creuset et de son contenu : si le creuset se contracte plus que le cristal pendant le refroidissement, celui-ci pourra être endommagé ou même fracturé, et il sera de toute façon impossible de l'extraire du creuset, qui devra être détruit ; dans le cas contraire, le cristal ne restera pas forcément intact non plus car il adhérera en général au creuset après la solidification, de sorte qu'il subira des contraintes de traction.

On a déjà eu l'idée d'employer des creusets en matériau suffisamment élastique pour que ces problèmes ne soient que peu gênants. Une autre idée consiste à intercaler une substance molle ou compressible entre le creuset et son contenu, par exemple un tissu comme dans la demande de brevet FR-A-2 345 253 ou un liquide, mais il est difficile d'en trouver qui convienne bien, car il faut qu'elle soit chimiquement compatible avec le contenu du creuset, c'est-à-dire qu'elle ne réagisse pas avec lui, qu'elle ne soit pas détruite par les températures atteintes et qu'elle ne perturbe pas le processus de solidification.

On a encore proposé d'isoler le creuset de son contenu en intercalant une couche gazeuse entre eux. Cette méthode implique, dans les conceptions connues, que la paroi du creuset soit poreuse et que le creuset soit creux pour qu'un gaz soit insufflé dans la chambre enclose par le creuset et en sorte par la paroi poreuse de manière à former une couche gazeuse qui repousse le liquide vers le centre du creuset comme dans les demandes de brevet EP-A-0 565 415 ou EP-A-0 070 760. Cette méthode est efficace et assez facile à mettre en oeuvre mais présente tout de même l'inconvénient que la forme du creuset doit être compliquée, notamment par l'existence de la paroi poreuse.

L'invention concerne un dispositif de cristallogenèse où une couche gazeuse est encore utilisée pour séparer le cristal de la paroi du creuset, mais elle diffère des dispositifs connus, car la paroi du creuset n'est pas poreuse et aucune couche gazeuse n'est créée au niveau du liquide.

Elle concerne précisément un dispositif comprenant un creuset clos dans lequel un cristal est formé par solidification d'un liquide, des moyens de création d'un champ thermique mobile le long du creuset, un conduit supérieur et un conduit inférieur débouchant à des hauteurs différentes dans le creuset, et des moyens de fourniture de gaz dans les conduits et le creuset, à une pression plus forte dans le conduit inférieur que dans le conduit supérieur et à une différence de pressions variable entre le conduit supérieur et le conduit inférieur.

Elle concerne aussi un procédé de cristallogenèse par le service de ce dispositif, caractérisé en ce que le conduit supérieur débouche au-dessus du liquide et le conduit inférieur débouche devant le cristal solidifié, et la pression dans le conduit inférieur excède la pression dans le conduit supérieur de sensiblement la pression de hauteur du liquide.

L'invention va maintenant être décrite en détail à l'aide des figures suivantes, annexées à titre illustratif et nullement limitatif :
- la figure 1 est une illustration schématique de l'invention,
- la figure 2 représente plus complètement un dispositif de mise en oeuvre de l'invention, et
- la figure 3 représente un autre mode de réalisation de l'invention.

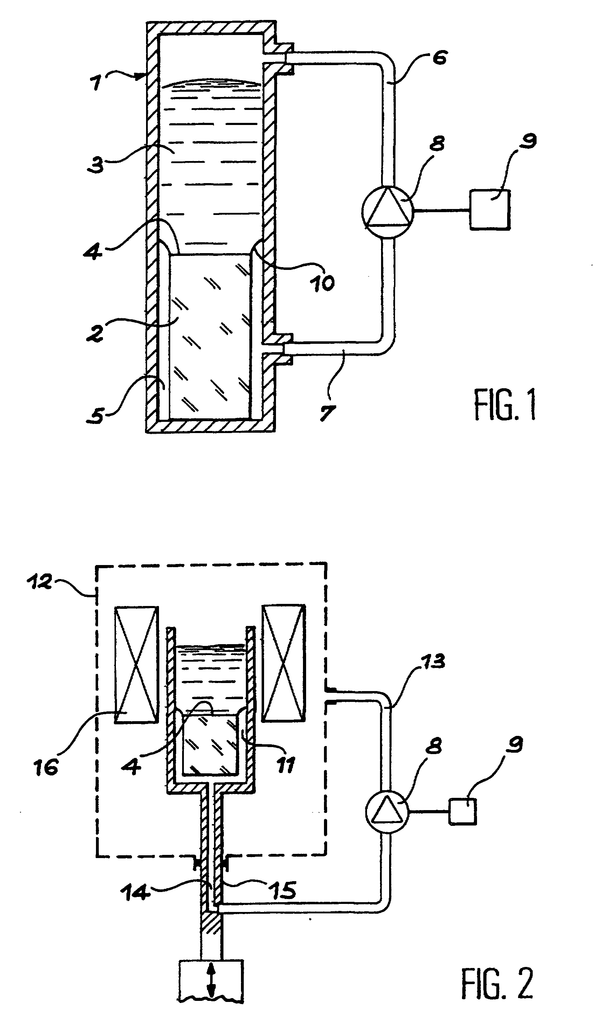

La figure 1 représente un creuset 1 cylindrique clos contenant un cristal 2 à sa partie inférieure et un liquide 3 à solidifier au-dessus d'une interface 4 avec le cristal 2. Le liquide 3 baigne la paroi du creuset 1, mais le cristal 2 est séparé de la paroi du creuset 1 par un jeu portant la référence 5. Un conduit supérieur 6 débouche dans le creuset 1 au-dessus de la surface libre du liquide 3, et un conduit inférieur 7 débouche également dans le creuset 1, à un niveau inférieur de celui-ci et en tout cas devant le cristal 2. Les conduits 6 et 7 se réunissent devant un système 8 créant une pression différentielle et qui peut constituer en une valve, une pompe ou un compresseur commandé par un régulateur 9 selon les principes donnés plus loin. L'interface 4 se raccorde à la paroi du creuset 1 par un ménisque 10 au-dessus du jeu 5.

La figure 2 montre qu'au sens de l'invention un creuset clos peut désigner un creuset 11 ouvert à sa partie supérieure mais enfermé dans une enceinte étanche 12 dans laquelle on maintient une atmosphère à la composition souhaitée. Le conduit supérieur, portant ici la référence 13, peut alors déboucher dans l'enceinte 12 ; le conduit inférieur 14 peut se terminer en une tige 15 verticale, coaxiale à l'enceinte 12 et aboutissant au fond du creuset 11, ce qui permet d'appliquer la conception de l'invention à des procédés où le germe cristallin déposé est de très petite hauteur.

Un four 16 ou un autre dispositif de chauffage est disposé dans l'enceinte 12 autour du creuset 11 ; la tige 15 de support du creuset 11, coulissant à travers l'enceinte 12, permet de mouvoir de l'extérieur le creuset 11 en direction verticale, et le creuset 11 est en fait abaissé progressivement pendant le processus de solidification, l'interface 4 restant au niveau de l'extrémité basse du four 16.

La pression injectée par le système 8 dans le conduit inférieur 7 ou 14 est supérieure à celle du conduit supérieur 6 ou 13 d'une valeur sensiblement égale à la pression hydrostatique du liquide 3, c'est-à-dire à la pression produite par la hauteur de la colonne de liquide 3, et la valeur précise à appliquer peut être déterminée par l'expérience ou par des essais comparatifs en fonction des propriétés de mouillage des phases en présence (gaz, liquide 3, cristal 2 et creuset 1). Cette différence de pression doit diminuer à mesure que le cristal 2 se solidifie et que la hauteur du liquide 3 diminue.

L'enseignement essentiel de l'invention est que le jeu 5 apparaît spontanément dans ces conditions quand le cristal 2 se solidifie. Il n'existe pas au niveau du liquide 3, ce qui n'est pas jugé important pour peu que le creuset 1 et le liquide 3 ne réagissent pas entre eux. Un seul orifice est nécessaire pour chacun des conduits, ce qui signifie que la paroi poreuse usuelle dans les techniques de sustentation par couche gazeuse est inutile.

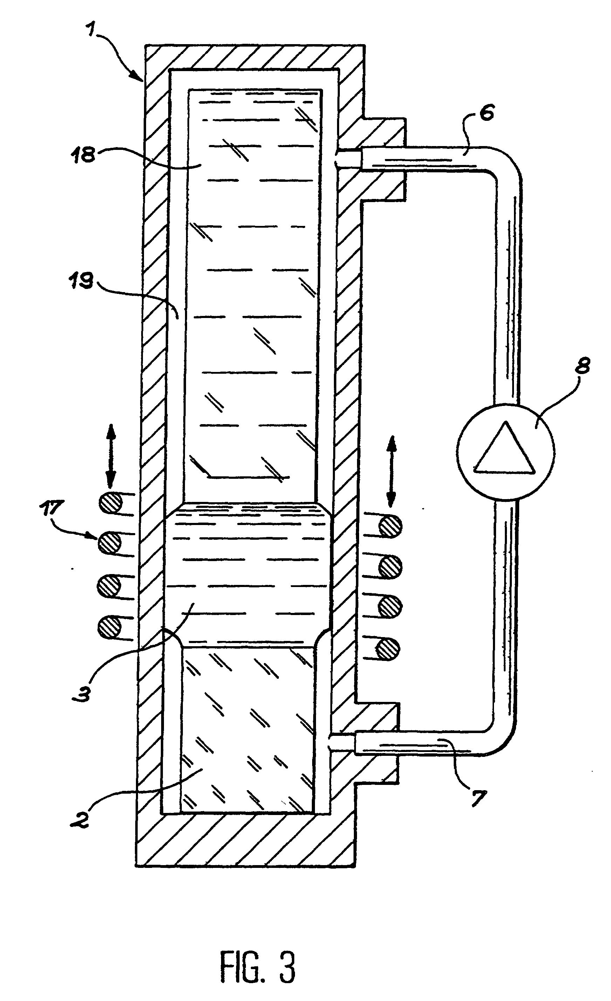

La figure 3 représente une autre situation avec le creuset de la figure 1. On emploie ici un procédé de solidification un peu différent, où le matériau devant former le cristal est déposé à l'état solide dans le creuset 1 avant d'être fondu et de se resolidifier ensuite en prenant la structure cristallographique du germe. L'élément de chauffage, portant ici la référence 17 et qui peut être de tout genre connu, par exemple un enroulement inducteur, a donc une hauteur beaucoup plus petite que dans le cas de la figure 2 et est déplacé le long du creuset 1 vers le haut. Le liquide 3 subsiste à hauteur des moyens de chauffage 17, et le sommet du creuset 1 est occupé par le matériau solide 18 à l'état initial, non cristallisé. Bien entendu, on a pris soin de maintenir un jeu initial 19 entre le matériau initial 18 et le creuset 1, pour que la pression originaire du conduit supérieur 6 puisse s'exercer jusqu'au niveau de la surface supérieure du liquide 3.

## Revendications

1. Dispositif de cristallogenèse comprenant un creuset clos (1,11,12) dans lequel un cristal (2) est formé par solidification d'un liquide (3), des moyens (16,17) de création d'un champ thermique mobile le long du creuset, **caractérisé en ce qu'**il comprend un conduit supérieur (6,13) et un conduit inférieur (7,14) débouchant à des hauteurs différentes dans le creuset (1,11), et des moyens (8) de fourniture de gaz dans les conduits et le creuset, à une pression plus forte dans le conduit inférieur que dans le conduit supérieur et à une différence de pression variable entre le conduit supérieur et le conduit inférieur.

2. Dispositif de cristallogenèse selon la revendication 1, **caractérisé en ce que** le creuset est composé d'un récipient (11) ouvert en haut et d'une enceinte (12) étanche contenant le récipient (11) et les moyens de création du champ thermique, le conduit supérieur (13) débouchant dans l'enceinte (12) et le conduit inférieur (14) débouchant dans le récipient (11).

3. Dispositif de cristallogenèse selon la revendication 2, **caractérisé en ce que** le conduit inférieur (14) se finit en une tige (15) de support du récipient (11) coulissant à travers l'enceinte (12).

4. Procédé de cristallogenèse par le service d'un dispositif de cristallogenèse comprenant un creuset clos (1,11,12) dans lequel un cristal (2) est formé par solidification d'un liquide (3), des moyens (16,17) de création d'un champ thermique mobile le long du creuset, un conduit supérieur (6,13) et un conduit inférieur (7,14) débouchant à des hauteurs différentes dans le creuset (1,11), et des moyens (8) de fourniture de gaz dans les conduits et le creuset, à une pression plus forte dans le conduit inférieur que dans le conduit supérieur et à une différence de pression variable entre le conduit supérieur et le conduit inférieur, **caractérisé en ce que** le conduit supérieur débouche au-dessus du liquide et le conduit inférieur débouche devant le cristal solidifié, et la pression dans le conduit inférieur excède la pression dans le conduit supérieur de sensiblement la pression de hauteur du liquide.

## Patentansprüche

1. Vorrichtung zur Kristallzüchtung, einen geschlossenen Tiegel (1,11,12), in dem ein Kristall (2) durch Erstarrung einer Flüssigkeit (3) gebildet wird, und Einrichtungen (16,17) zur Erzeugung eines längs des Tiegels beweglichen thermischen Feldes umfassend,
**dadurch gekennzeichnet,**
**dass** sie eine obere Leitung (6,13) und eine untere Leitung (7,14) enthält, die in unterschiedlichen Höhen in dem Tiegel (1,11) münden, und Einrichtungen (8) zur Einspeisung von Gas in die Leitungen und den Tiegel, wobei der Druck in der unteren Leitung höher ist als in der oberen Leitung und die Druckdifferenz zwischen der oberen Leitung und der unteren Leitung verstellbar bzw. einstellbar ist, und die obere Leitung (13) in dem Gehäuse (12) mündet, und die untere Leitung (14) in dem Behälter (11) mündet.

2. Vorrichtung zur Kristallzüchtung nach Anspruch 1, **dadurch gekennzeichnet, dass** der Tiegel durch einen oben offenen Behälter (11) und ein den Behälter (11) und die Einrichtungen zur Erzeugung des thermischen Felds enthaltendes dichtes Gehäuse (12) gebildet wird.

3. Vorrichtung zur Kristallzüchtung nach Anspruch 2, **dadurch gekennzeichnet, dass** die untere Leitung (14) in einer Tragstange (15) des Behälters (11) endet, die durch den Behälter (12) verschiebbar ist.

4. Verfahren zur Kristallzüchtung mittels einer Kristallzüchtungsvorrichtung mit einem geschlossenen Tiegel (1,11,12), in dem ein Kristall (2) durch Erstarrung einer Flüssigkeit (3) gebildet wird, mit Einrichtungen (16,17) zur Erzeugung eines längs des Tiegels beweglichen thermischen Feldes, einer oberen Leitung (6,13) und einer unteren Leitung (7,14), die in unterschiedlichen Höhen in dem Tiegel (1,11) münden, und Einrichtungen (8) zur Einspeisung von Gas in die Leitungen und den Tiegel, wobei der Druck in der unteren Leitung höher ist als in der oberen Leitung und die Druckdifferenz zwischen der oberen Leitung und der unteren Leitung verstellbar bzw. einstellbar ist, **dadurch gekennzeichnet, dass** die obere Leitung über der Flüssigkeit mündet und die untere Leitung vor bzw. gegenüber dem erstarrten Kristall mündet, und der Druck in der unteren Leitung den Druck in der oberen Leitung im Wesentlichen um den Druck der Flüssigkeitshöhe bzw. des Flüssigkeitspegels übersteigt.

## Claims

1. Crystallogenesis device comprising a closed crucible (1, 11, 12), in which a crystal (2) is formed by the solidification of a liquid (3) and means (16, 17) for creating a mobile thermal field along the crucible, **characterized in that** it has an upper duct (6, 13) and a lower duct (7, 14) issuing at different heights into the crucible (1, 11), and means (8) for supplying gas to the ducts and crucible at a higher pressure in the lower duct than in the upper duct and with a variable pressure difference between the upper duct and lower duct.

2. Crystallogenesis device according to claim 1, **characterized in that** the crucible is constituted by a container (11) which is open at the top and a tight enclosure (12) containing the container (11) and the thermal field creating means, the upper duct (13) issuing into the enclosure (12) and the lower duct (14) issuing into the container (11).

3. Crystallogenesis device according to claim 2, **characterized in that** the lower duct terminates in a support rod (15) for the container (11) sliding through the enclosure (12).

4. Crystaliogenesis process using the crystalloqenesis device comprising a closed crucible (1, 11, 12), in which a crystal (2) is formed by solidification of a liquid (3), means (16, 17) for creating a mobile thermal. field along the crucible, an upper duct (6, 13) and a lower duct (7, 14) issuing at. different heights into the crucible (1, 11) and means (8) for supplying gas to the ducts and crucible at a higher pressure to the lower duct than to the upper duct and with a variable pressure difference between the upper duct and the lower duct, **characterized in that** the upper duct issues above the liquid and the lower duct issues in front of the solidified crystal, and the pressure in the lower duct exceeds the pressure in the upper duct substantially by the height pressure of the liquid.
